# EUROPÄISCHE PATENTSCHRIFT

(11) **EP 3 455 390 B1**
(45) Veröffentlichungstag und Bekanntmachung des Hinweises auf die Patenterteilung: **28.09.2022**
(21) Anmeldenummer: 17730651.1
(22) Anmeldetag: 12.05.2017
(51) Int. Cl.: C23C 16/455

(54) **GASINJEKTOR FÜR REAKTIONSBEREICHE**
GAS INJECTOR FOR REACTION REGIONS
INJECTEUR DE GAZ POUR ZONES DE RÉACTION

(30) Priorität: 12.05.2016 DE 102016108845
(43) Veröffentlichungstag der Anmeldung: 20.03.2019
(73) Patentinhaber: Wege, Stephan, 01728 Bannewitz-Cunnersdorf (DE)
(72) Erfinder: Wege, Stephan, 01728 Bannewitz-Cunnersdorf (DE)
(74) Vertreter: Willems, Volker
(86) Internationale Anmeldenummer: PCT/DE2017/100403
(87) Internationale Veröffentlichungsnummer: WO 2017/194059

(56) Entgegenhaltungen:
- WO-A1-02/40741
- JP-A- H02 273 535
- US-A- 5 851 294
- US-A1- 2006 065 368
- US-A1- 2007 087 296

## Beschreibung

### Technisches Gebiet

Die Erfindung betrifft einen Gasinjektor zum Zuführen von Gas oder eines Gasgemisches in einen Reaktionsbereich, umfassend
a) einen Grundkörper mit einem Gaskanal,
b) eine erste Öffnung oder einen ersten Gruppenverbund von Öffnungen in dem Grundkörper, über welche das Gas oder Gasgemisch aus dem Gaskanal in den Reaktionsbereich gelangt, wobei
c) eine zweite Öffnung oder ein zweiter Gruppenverbund von Öffnungen im Grundkörper vorgesehen ist, über welche das Gas oder Gasgemisch ebenfalls aus dem Gaskanal in den Reaktionsbereich gelangt,
d) den Öffnungen oder den Gruppenverbünden von Öffnungen eine Gaszuführung im Grundkörper am Gaskanal zugeordnet ist.

### Beschreibung

Solche Gasinjektoren kommen vorwiegend bei der Herstellung von integrierten Schaltkreisen auf Halbleiterbasis zum Einsatz. Hier werden so genannte Wafer in einem Reaktionsbereich einem Gas oder Gasgemisch ausgesetzt, um einzelne Gasmoleküle zur Adsorption zu Atomlagen auf die Substratoberfläche zu bringen. Die Substrate werden hierfür in einem Reaktionsraum eingebracht. Über einen Gasinjektor wird in den Reaktionsraum das Gas oder das Gasgemisch eingebracht. Dabei kommt es besonders darauf an, dass die Oberfläche des Substrats gleichmäßig das Gas bzw. Gasgemisch adsorbiert. Dafür muss das Gas sehr homogen und uniform an die Oberfläche herangeführt werden. Bei den bekannten Gasinjektoren zeigt sich, dass die Homogenität und die Uniformität hinsichtlich der Strömungen des Gases bei der Benetzung des Substrats relativ schlecht ausgebildet sind. Dies gilt insbesondere dann, wenn mit einem kurzen Gaspuls gearbeitet werden soll.

Solche Gasinjektoren werden weiterhin auch bei Verbrennungsvorgängen, wie beispielsweise einer Gasheizung, verwendet. Hierbei kommt es ebenfalls auf einen gleichmäßigen Verbrennungsvorgang an. Das zu verbrennende Gas soll mit dem Sauerstoff für eine Oxidation möglichst gleichmäßig und homogen in Verbindung gebracht werden.

### Stand der Technik

Aus der DD 251453 A1 ist eine Einrichtung zur Erzeugung von atomaren Teilchenströmen mit hoher Intensität durch Dissoziation von Gasmolekülen eines Molekulargases in einer Niederdruckbogenentladung bekannt. Die Einrichtung bestehend aus einer stabförmigen, mit einer elektrischen Zuführung versehenen Kathode und einer Anode. Die auf Massepotential befindliche Anode umschließt die Kathode, weiche durch Isolierkörper von der Kathode isoliert ist. Die Anode ist mit einem Gaseinlass sowie einem Gasauslass versehen. Dabei befindet sich der Gasauslass in unmittelbarer Nähe eines Endes der Kathode. Die Anode, die Kathode und die Isolierkörper sind von einem elektrisch leitenden, gegenüber seiner Umgebung elektrisch isolierten Körper umgeben, der jeweils eine Durchführung für die Anode und die Kathode sowie eine Gaseinlass- und eine Gasauslassdurchführung aufweist. Dabei ist die Gasauslassdurchführung in unmittelbarer Nähe und konzentrisch zum Gasauslass der Anode angeordnet.

Die DD 281425 C4 beschreibt eine Vorrichtung zur plasmagestützten Abscheidung oder Abtragung dünner Schichten mit zylinderförmiger Elektrodenanordnung. Die Elektrodenanordnung besteht aus einem als Rezipient ausgebildeten Gehäuse.

Das Gehäuse ist mit einer Vakuumerzeugungseinrichtung verbunden, welche über Mittel zur Zuführung eines Reaktionsgases verfügt. In dem Gehäuse sind ferner die Ladung erzeugenden, mit einer HF-Spannungsquelle verbundenen Elektroden untergebracht. Die Elektroden sind als Zylinder ausgebildet und koaxial zueinander angeordnet. Die innere Elektrode ist dabei als Substrathalter ausgestaltet. Ein Hohlzylinder aus Metall ist regelmäßig mit Kanälen zum Gaseinlass und zur Absaugung versehen. Zwischen diesen Kanälen sind Kammern zur Aufnahme von Permanentmagneten eingebracht. Dieser Hohlzylinderkorb ist an der Außenseite mit einem Blechmantel und an der Innenseite durch einen perforierten Blechmantel abgedeckt. Die Gaszuführungen und Absaugungen, die zur Außenelektrode von Sammelkanälen ausgehen, sind alternierend auf dem Umfang verteilt und an der Stirnseite der Elektrode angeordnet. Der Plasmaraum ist an den Enden durch Platten aus hochisolierendem Material mit kleinem dielektrischem Verlustwinkel abgedeckt.

Aus der DE 60 2004 010 930 T2 ist ein Verfahren und eine Vorrichtung zur Abscheidung von Schichten bekannt. Im Besonderen dienen sie zur Herstellung eines konformalen Dünnfilms auf einem Substrat. Die Vorrichtung zum Herstellen von konformalen Dünnfilmen auf einem Substrat umfasst eine Zerstäuberplatte, die einen Vorsprung aufweist. Der Vorsprung reduziert Turbulenzen in einem Expansionsvolumen, das zu einem Gasinjektor gehört. Entsprechend umfasst das Verfahren zum Herstellen von konformalen Dünnfilmen auf einem Substrat das Einbringen eines Gases von einem Gaseinlass in ein Expansionsvolumen, das zu einer Anordnung zur Atomlagenabscheidung (ALD) gehört. Das Gas wird durch eine dem Expansionsvolumen benachbarte Zerstäuberplatte und eine Reaktionskammer geführt. Die Zerstäuberplatte umfasst einen Vorsprung, der sich gegenüber dem Gaseinlass befindet, wodurch Turbulenzen im Expansionsvolumen reduziert werden.

In der WO 97/37059 wird ein Brausekopf zum gleichmäßigen Verteilen von Prozessgas beschrieben, wie zum Beispiel chemisch reaktives Gas über eine Halbleiter-SubstratOberfläche, um die Speziesausnutzung an der Substratoberfläche zu erweitern. Gasplasmatechnologie ist eine sehr bekannte Technik, welche benutzt wird für die Herstellung von integrierten Schaltkreisen. Im Einzelnen wird Plasmatechnologie mit großem Erfolg für Dünnfilmätzen benutzt, das Aufdampfen von Filmen auf Halbleiterscheiben (Wafer), Photoresist-Strippen, etc. Bekannterweise hat es sich manchmal als schwierig erwiesen, die gleichmäßige Verteilung eines reaktiven Gases über einer Halbleiterscheibe während der Bearbeitung sicherzustellen. Es ist insbesondere problematisch, eine gleichmäßige Verteilung von Gas über der Halbleiterscheibe (semiconductor wafer) sicherzustellen, um Photoresist-Strippen auszuführen. Eine Prozesskammer wird beschrieben, welche das Problem der nicht gleichförmigen Verteilung der reaktiven Spezies aufweist. Ein Gas beinhaltet aktive Spezies und wird durch einen Zentralkanal in die Prozesskammer geleitet. Das Gas reagiert mit der Oberfläche der Halbleiterscheibe, welche auf einer Platte positioniert ist, und tritt dann durch einen zentralen Auslasskanal aus. Die Verweilzeit des Gases in der Kammer ist typischerweise kurz (zum Beispiel einige Millisekunden).

Die WO 02/097870 A2 offenbart einen Diffusor in Plasma-Bearbeitungssystemen. Dort wird beschrieben, dass Halbleiter-Bearbeitungssysteme verwendet werden, um Halbleiterwafer für die Herstellung von integrierten Schaltkreisen zu bearbeiten. Beim Ätzen, Oxidieren, bel chemischer Gasphasenabscheidung (CVD) usw. werden plasmabasierte Halbleiterbearbeitungsprozesse verwendet. Konventionelle Plasma-Bearbeitungssysteme steuern einen Gas- oder Plasmastrom in einer Plasma-Bearbeitungskammer, um eine optimale Umgebung zur Bearbeitung des Wafers bereitzustellen. In der Bearbeitungskammer wird der Wafer bearbeitet (z. B. durch Ätzen, Oxidation, CVD usw.), indem der Wafer einem Gas oder Plasma ausgesetzt wird, die in die Kammer hinein und aus ihr hinaus gepumpt werden. Dieser Prozess ändert die Charakteristiken des Wafers. Dort wird beschrieben, dass die Zyklusgeschwindigkeit einer Kammer bei konventionellen Bearbeitungssystemen im Allgemeinen in der Praxis durch die maximale lokale Geschwindigkeit der einströmenden und ausströmenden Gase beschränkt wird.

Aus der WO 2006/039211 A2 ist bekannt, dass in einem Plasmaverarbeitungssystem eine integrierte Gasflusssteueranordnung zur Verbindung ein Gasverteilungssystem zu einer Injektor Multi-Zone vorgesehen ist. Kanäle verbinden in dem Gasverteilungssystem mehrere Ventilanordnungen zur Gasflusssteuerung,

Die US 2006/006 5368 A1 beschreibt einen Gasinjektor mit einem Grundkörper, welcher als Verteilerringrohr ausgebildet ist. In dem Verteilerringrohr sind Zerstäuberdüsen vorgesehen, welche ein Gas bzw. ein Gasgemisch in einen zentralen Reaktionsraum führen. Das Verteilerringrohr wird über eine Gaszuliefererleitung mit Gas versorgt. Um eine möglichst gleichmäßige Verteilung des Gasstroms zu erzeugen, ist zwischen Anschlüssen des Verteilerringrohrs und der Gaszuliefererleitung ein Verteilerelement vorgesehen. Das Verteilerelement ist wiederum über mehrere parallele Gaszulieferleitungen mit dem Verteilerringrohr verbunden. Die Anschlüsse des Verteilerringrohrs sind dazu symmetrisch um den Körper vorgesehen.

Die US 5,851,294 beschreibt eine Gasinjektionsanordnung, welche eine Hauptkammer umfasst, die über einen Einlass und einer Versorgungsleitung mit einer Gasquelle gekoppelt ist. Die Hauptkammer ist durch eine Leitungsstruktur, mit Düsen verbunden. Dies ist so konfiguriert, dass der Gegendruck eines Plenums ausgeglichen wird, so dass die Düsen Gas mit einer im Wesentlichen gleichmäßigen Durchflussrate in die Kammer injizieren. Die Leitungsstruktur umfasst mehrere separate Kanäle oder Durchgänge, die sich von der Hauptkammer zu den Düsen erstrecken. In einer Ausführungsform wird ein separater Kanal für jede Düse verwendet, obwohl derselbe Kanal, falls gewünscht, zwei oder mehr Düsen mit der Hauptkammer verbinden kann. Eine Optimierung des Drucks zur Gleichverteilung des Gases in der Leitungsstruktur wird nicht offenbart.

Aus der US 2007/087296 A1 sind eine Gasversorgungseinrichtung und eine Vorrichtung zum Bearbeiten eines Substrats mit der Gasversorgungseinrichtung bekannt, beispielsweise eine Gasversorgungseinrichtung zum Zuführen eines Reaktionsgases auf ein Substrat. Dabei weist die Gasversorgungsvorrichtung mehrere Gasversorgungsleitungen auf, die jeweils mit dem einem Gasversorgungselement verbunden sind. Die Gasversorgungsleitungen sind jeweils mit einem Gasspeicher oder mehreren Gasspeichern verbunden. Düsen, die mit dem Gasversorgungselement verbunden sind, durch verlaufen die Wand einer Kammer und erstrecken sich in Richtung des in die Kammer geladenen Substrats. Eine Optimierung des Drucks zur Gleichverteilung an den Düsen erfolgt nicht.

Die WO 02/40741 A1 betrifft eine Vorrichtung zum Einbringen von Gas in einen Schnellglüh- oder einen chemischen Gasphasenabscheidungsreaktor mit mehreren Einspritzrampen, die in einem Sprühring angeordnet sind. Der Sprühring erstreckt sich jeweils innerhalb einer Kammer gegenüber einem Fenster. Jede Rampe ist mit Öffnungen ausgestattet, die im Durchmessern so kalibriert sind, dass sie Gasstrahlen in vorbestimmter Richtungen auf das Substrat richten. Eine Spendersäule ist mit dem Ring verbunden, um die Rampen von einem externen Kreislauf des Gaseinlasses zu speisen. Die Vorrichtung lässt sich bei Schnellglühofen und / oder eine chemische Dampfabscheidung zum Behandeln von Substraten mit großen Oberfläche verwenden.

Die bekannten Gasinjektoren haben den Nachteil, dass die Verteilung des Gases im Reaktionsbereich durch insbesondere unterschiedliche Druck- und Strömungsverhältnisse nicht homogen und gleichmäßig auf die Öffnungen bzw. Gruppenverbünden von Öffnungen erfolgt. Ursache ist hier häufig die Verwirbelung und Reibung in dem Gaskanal. Dies hat letztendlich zur Folge, dass es zu ungleichmäßigen chemischen Reaktionen im Reaktionsbereich kommen kann. Besonders bei kurzen Gaspulsen führt diese Gasungleichverteilung zu Problemen. Oft ist der Reaktionsbereich, wo eine hinreichende Homogenität für Reaktionen herrscht, daher nur sehr beschränkt. Die Größe der Substrate, welche mit einem Gas oder Gasgemisch reagieren soll, wie Wafer, ist hierdurch stark eingeschränkt.

Außerdem hat die Inhomogenität und Ungleichförmigkeit des Gases schließlich zur Folge, dass insbesondere die erforderliche Reaktionszeit mit einem Substrat oder sonstigen chemischen Elementen im Reaktionsbereich ungleich abläuft. Dadurch verlängern sich die Verweilzeiten während des Bearbeitungsprozesses.

### Offenbarung der Erfindung

Aufgabe der Erfindung ist es daher, die Nachteile des Standes der Technik zu beseitigen und einen Gasinjektor zu schaffen, welcher eine kompakte Bauweise aufweist. Dabei soll ein Reaktionsbereich vorhanden sein, bei dem die Verteilung eines erforderlichen Gases oder Gasgemisches zur Reaktion im Reaktionsbereich möglichst gleich verteilt ist.

Erfindungsgemäß wird die Aufgabe dadurch gelöst, dass bei dem Gasinjektor zum Zuführen von Gas oder eines Gasgemisches in einen Reaktionsbereich der eingangs genannten Art
a) die Gaszuführung mit dem Gaskanal mit einem ersten Verbindungsteil an einer Verbindungsstelle verbunden ist, wobei an dem ersten Verbindungsteil ein Abzweig vorgesehen ist, welcher in einen Bypass mündet und der Bypass zu einem zweiten gegenüberliegenden Verbindungsteil an einer weiteren Verbindungsstelle führt, welches ebenfalls mit dem Gaskanal des Grundkörpers verbunden ist, wobei das Gas oder Gasgemisch über die zwei Verbindungsstellen in den Gaskanal des Grundkörpers strömt.

Bei einer einzelnen Gaszuführung, wie es häufig beim Stand der Technik verwendet wird, kommt es am Gaskanal strömungs-, temperatur- und vor allem druckbedingt zu einer Ungleichverteilung hinsichtlich des in den Reaktionsbereich einströmenden Gases oder Gasgemisches. Die Erfindung beruht daher insbesondere auf dem Prinzip, diese Ungleichverteilung zum Reaktionsbereich hin zu beseitigen. Dabei hat sich überraschenderweise gezeigt, dass es besonders vorteilhaft ist, der Öffnung oder einem Gruppenverbund von Öffnungen des Gasinjektors jeweils eine separate Gaszuführung zuzuordnen. Auf diese Weise lässt sich die Druck- und Strömungsverteilung erheblich homogener im Reaktionsbereich ausgestalten. Damit lassen sich zum einen die Reaktionszeiten mit einem Substrat erheblich verkürzen, womit sich sehr kurze Gaspulszeiten realisieren lassen. Die Gaspulszeit ist die Zeit, in der sich das Gas zur Reaktion mit der Substratoberfläche im Reaktionsbereich befindet. Durch die Anordnung einer separaten Gaszuführung in dem Grundkörper lässt sich bereits bei der Herstellung des Gasinjektors klar definieren, wie das Gas die Gaskanäle zu durchströmen hat.

Zum anderen ist die Verteilung des Gases oder des Gasgemisches auf der Substratoberfläche im Reaktionsbereich zudem erheblich gleichmäßiger. Die Verwirbelungen und Reibungen im Gaskanal werden durch diese Maßnahme minimiert. Es kommt somit zu einer erheblich höheren Homogenität des Gases im Gaskanal und damit auch im Reaktionsbereich. Eine als ein Bypass einer anderen Gaszuführung ausgebildete separate Gaszuführung hilft dabei Ressourcen zu sparen. Es ist nicht mehr erforderlich, dass jeder Öffnung bzw. Gruppenverbund von Öffnungen jeweils eine eigene Gasressource zur Versorgung der separaten Gaszuführungen zuzuordnen ist. Vielmehr kann hierdurch eine Gasressource verwendet werden, welche alle Öffnungen bzw. Gruppenverbünde von Öffnungen versorgen kann.

Indem der Bypass in dem Grundkörper angeordnet ist, lässt sich eine kompakte Bauweise erzielen. Quasi als Nebeneffekt wird der Strömungszufluss optimiert. Damit lässt sich eine erheblich höhere Qualität bei der Reaktion zwischen Gas und Substrat erreichen. Vorzugsweise befindet sich der Bypass parallel zum ersten Gaskanal. Der Bypass kann dabei einerseits neben und andererseits auch unter bzw. über dem Gaskanal im Grundkörper vorgesehen sein.

Um eine besonders gleichmäßige Strömung zu erhalten, kann die als Bypass ausgebildete Gaszuführung einen unterschiedlichen Durchmesser und/oder Länge zum ersten Gaskanal aufweisen. Mit den unterschiedlichen Durchmessern bzw. Längen erhält man zusätzliche Parameter, um die Strömung zu den Öffnungen bzw. den Gruppen von Öffnungen im Hinblick auf eine gleichmäßige Strömungsverteilung an den Öffnungen zu optimieren. Dabei kann, falls erforderlich, der Durchmesser auch innerhalb eines Gaskanals variieren, insbesondere auch im Bypass.

Eine bevorzugte Ausbildung des erfindungsgemäßen Gasinjektors besteht ferner darin, dass der Durchmesser und/oder die Länge der Gaszuführungen einstellbar und/oder veränderbar ausgebildet sind. Die Veränderbarkeit der Durchmesser und/oder der Länge der Gaszuführungen ermöglicht zusätzlich den Gasstrom hinsichtlich der Homogenität zu optimieren. Das Gas bzw. Gasgemisch erreicht so sehr gleichmäßig die Öffnungen oder die Gruppen von Öffnungen.

In einer besonders bevorzugten Ausbildung des erfindungsgemäßen Gasinjektors ist der Reaktionsbereich in einem geschlossenen Reaktionsraum vorgesehen. Hierdurch kann der Reaktionsraum eingegrenzt werden und von Störungen durch Fremdeinflüsse, wie unerwünschte Gase bzw. Gasgemische, freigehalten werden. Grundsätzlich kann der Reaktionsraum beispielsweise für eine Wafer-Bearbeitung bei integrierten Schaltungen auf Halbleiterbasis als Vakuum ausgebildet sein, um z.B. gezielt Gase in diesen Reaktionsraum einzuführen. Die Gase können mit der Oberfläche des Wafers zur Ablagerung einer dünnen Atomschicht oder von Atomschichten reagieren.

Eine vorteilhafte Ausgestaltung des erfindungsgemäßen Gasinjektors wird dadurch erreicht, dass die Öffnung bzw. die Öffnungen im Grundkörper jeweils als eine Lavaldüse ausgebildet sind. Beim Durchströmen der Öffnungen gelangt das Gas bzw. Gasgemisch in den Reaktionsbereich. Es zeigt sich, dass Lavaldüsen besonders gute Strömungseigenschaften aufweisen, um dabei in dem Reaktionsbereich eine homogene Gasverteilung zu erzielen.

Zur weiteren Optimierung des Gaseinlasses in den Reaktionsbereich ist in einer vorteilhaften Ausgestaltung des erfindungsgemäßen Gasinjektors der Austrittswinkel der Öffnung bzw. der Öffnungen in eine horizontale und/oder eine vertikale Richtung verstellbar ausgestaltet. Hierdurch lässt sich noch gezielter eine Homogenität des Gases bzw Gasgemisches im Reaktionsbereich herstellen. Durch geeignete Justierung der Strömungsrichtung des Gases aus den Öffnungen in den Reaktionsbereich lassen sich insbesondere strömungs-, temperatur- und druckabhängige inhomogene Verteilungen im Reaktionsbereich zusätzlich kompensieren.

Vorzugsweise lassen sich nicht nur die Richtungen der Austrittswinkel der Öffnung bzw. der Öffnungen zur Optimierung des Gaszustroms variieren, sondern auch die Strömungsgeschwindigkeit. Hierzu ist in einer zweckmäßigen Ausbildung des erfindungsgemäßen Gasinjektors der Öffnungswinkel und/oder der Öffnungsdurchmesser der Öffnung bzw. der Öffnungen variabel ausgestaltet. Damit hat der Anwender einen weiteren Parameter, um Einfluss auf die Strömung in den Reaktionsbereich zu nehmen, um eine hinreichende Homogenität in einem möglichst großen Bereich zu erhalten.

Um einen weiteren optimierbaren Parameter zur Steuerung des Gaseinlass in den Reaktionsbereich zu erhalten, ist in einer vorteilhaften Ausgestaltung des erfindungsgemäßen Gasinjektors eine Heizung zur Erwärmung des Gases vorgesehen. Über die Temperatur lässt sich der Gasdruck insbesondere im Grundkörper bzw. im Gaskanal variieren. Hierzu kann in einer weiteren zweckmäßigen Ausgestaltung der Erfindung individuell eine Heizung an jeder Öffnung vorgesehen sein, die jeweils individuell ansteuerbar und beheizbar ausgebildet ist.

Eine bevorzugte Ausbildung des erfindungsgemäßen Gasinjektors besteht dann darin, dass ein Temperaturmesssensor vorgesehen ist, welcher die Temperatur des Gasinjektors zur Steuerung der Heizung überwacht. Über den Temperaturmesssensor kann die jeweilige Temperatur ermittelt werden. Die Heizung kann anhand der Temperaturmesswerte angesteuert und entsprechend optimiert werden.

In einer weiteren vorteilhaften Ausbildung des erfindungsgemäßen Gasinjektors ist ein Druckmesssensor vorgesehen, welcher den Gasdruck des Gasinjektors zur Steuerung des Gasdrucks überwacht. Über den Druckmesssensor lässt sich ermitteln, welcher Druck vorliegt. Hier können Druckschwankungen ermittelt und ausgewertet werden.

Mittels des Druckmesssensors lässt sich aber auch eine Steuerung des Drucks realisieren. Sollte der Druck beispielsweise zu gering sein, so lässt sich über die Heizung der Druck optimieren, sofern sie entsprechend angesteuert wird. Auch der Zustrom von Gasressourcen kann hierüber geregelt werden.

Eine besondere Ausbildung des erfindungsgemäßen Gasinjektors besteht vorzugsweise darin, dass der Gasinjektor eine ring- oder polygonartige Struktur aufweist, wobei der Austrittswinkel der Öffnung bzw. Öffnungen jeweils zentral ausgerichtet ist. Die Anordnung erweist sich als besonders gut, da sich hiermit leicht ein begrenzter Reaktionsbereich im Inneren der ring- oder polygonartigen Struktur definieren lässt. Dieser Reaktionsbereich kann gezielt beim Gaszufluss optimiert werden.

Oft tauchen bei Gasinjektoren relativ große Probleme auf, weil sie sich bei Hitze verformen. Diese Verformung kann sowohl während des Betriebs des Gasinjektors, als auch bei der Herstellung vorkommen. Eine besonders vorteilhafte Ausgestaltung des erfindungsgemäßen Gasinjektors besteht daher darin, dass der Gasinjektor einen keramischen Grundkörper enthält. Gasinjektoren aus diesem Material sind zwar relativ spröde, aber dafür extrem hitzebeständig. Zusätzlich eignen sich auch keramische Werkstoffe, wie z.B Aluminiumoxid, Zirkoniumoxid, Yttriumoxid, die sehr plasmaresistent und mit einer geringen Sputterrate in aller Regel chemisch sehr widerstandsfähig sind. Daher widerstehen diese Werkstoffe auch sehr agressiven Ätzgasen, wie beispielsweise Halogenen. Sie verformen sich für den Anwendungsbereich praktisch überhaupt nicht.

Eine bevorzugte Ausgestaltung des erfindungsgemäßen Gasinjektors wird schließlich dadurch erzielt, dass die Öffnungen oder Gruppenverbände von Öffnungen symmetrisch am Grundkörper angeordnet sind. Symmetrische Anordnungen lassen sich besonders gut berechnen und optimieren, Insofern ist diese symmetrische Anordnung der Öffnungen an dem Grundkörper zur Erzeugung eines uniförmigen und homogenen Gasstroms im Reaktionsbereich besonders geeignet.

In einer vorteilhaften Ausgestaltung des erfindungsgemäßen Gasinjektors ist ein zum ersten Gaskanal paralleler zweiter Gaskanal vorgesehen, welcher in dem Grundkörper angeordnet ist. Dabei sind für den zweiten Gaskanal Öffnungen oder ein Gruppenverbund von Öffnungen vorgesehen, über welche ein zweites Gas oder Gasgemisch aus dem zweiten Gaskanal unabhängig von dem ersten Gaskanal in den Reaktionsbereich gelangt. Durch diese Maßnahme lassen sich noch weitere Parameter im Reaktionsbereich des Gasinjektors variieren, um so eine geeignete Reaktion mit einem Substrat herbeizuführen. Dabei können die Gaskanäle beispielsweise auch abwechselnd oder in bestimmten Sequenzen abwechselnd mit den unterschiedlichen Gasen gepulst beaufschlagt werden. Auch die Gasdrücke der einzelnen Gaskanäle können jeweils variieren.

Weitere Ausgestaltungen und Vorteile ergeben sich aus dem Gegenstand der Unteransprüche, sowie den Zeichnungen mit den dazugehörigen Beschreibungen. Ausführungsbeispiele sind nachstehend unter Bezugnahme auf die beigefügten Zeichnungen näher erläutert. Dabei soll sich die Erfindung nicht auf die Ausführungsbeispiele beschränken. Hierbei handelt es sich lediglich um prinzipielle und exemplarische Realisierungen des Gasinjektors. Vielmehr sind ausdrücklich auch Ausführungen angedacht, die sich jetzt und zukünftig in äquivalenter Weise dem Fachmann auch mit anderen technischen Hilfsmitteln ergeben.

### Kurze Beschreibung der Zeichnung

- Fig. 1: zeigt in einer schematischen Prinzipskizze einen erfindungsgemäßen ringförmigen Gasinjektor, bei dem jeder Öffnung eine Gaszuführung zugeordnet ist.
- Fig. 2: zeigt in einer schematischen Prinzipskizze einen erfindungsgemäßen ringförmigen Gasinjektor mit einer Gaszuführung und einem Bypass.
- Fig. 3: zeigt in einer schematischen Prinzipskizze einen Schnitt eines Gasinjektors mit Lavaldüsen.
- Fig. 4: zeigt in einer schematischen Prinzipskizze einen Schnitt einer variablen Lavaldüse, wie sie bei dem erfindungsgemäßen Gasinjektor verwendet wird.
- Fig. 5: zeigt in einer schematischen Prinzipskizze einen erfindungsgemäßen ringförmigen Gasinjektor, bei dem eine zweite separate Gaszuführung mit zur ersten Gaszuführung unabhängigen Öffnungen vorgesehen ist.

### Bevorzugtes Ausführungsbeispiel

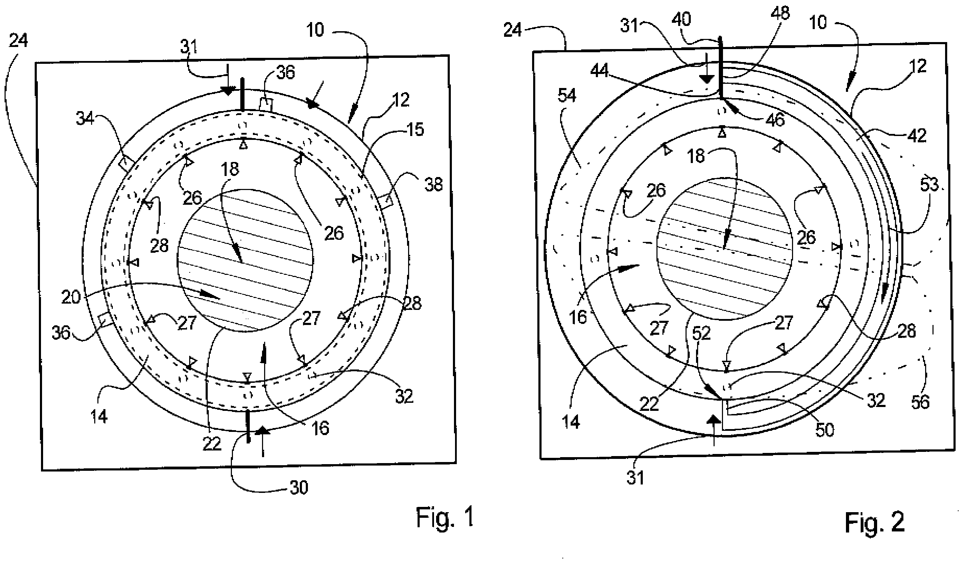

In Fig. 1 wird mit 10 ein erfindungsgemäßer Gasinjektor bezeichnet. Der Gasinjektor 10 ist in einer schematischen Prinzipskizze dargestellt. Der Gasinjektor 10 besteht aus einem ringförmigen Grundkörper 12, in welchem ein ebenfalls ringförmiger Gaskanal 14 vorgesehen ist. Der Grundkörper 12 weist einen zweiten Gaskanal 15 auf, welcher parallel und unterhalb zum ersten Gaskanal 14 angeordnet ist. Der zweite Gaskanal 15 ist gestrichelt dargestellt. Der zweite Gaskanal 15 kann dabei alternativ neben oder über dem ersten Gaskanal 14 angeordnet sein. Der Grundkörper 12 besteht aus einem keramischen Material. Das keramische Material ist extrem hitzebeständig, wie es für die Anforderungen bei dem Gasinjektor 10 regelmäßig erforderlich ist. Der Grundkörper 12 ist um einen Reaktionsbereich 16 angeordnet. Im Inneren, dem Zentrum 18 des Reaktionsbereichs 16 befindet sich ein Substrat 20, welches in vorliegenden Ausführungsbeispielen beispielsweise als Wafer 22 ausgebildet ist. Der Reaktionsbereich 16 ist in einem Reaktionsraum 24 vorgesehen. Das Substrat 20 soll in dem Reaktionsbereich 16 möglichst gleichmäßig mit einem Reaktionsgas reagieren.

Der Grundkörper 12 des Gasinjektors 10 hat daher Öffnungen 26, 27, welche zum Zentrum 18 des Reaktionsbereichs 16 hin zeigen. Die Öffnungen 26, 27 sind symmetrisch im Grundkörper 12 angeordnet. Ein Teil der Öffnungen 26, 27 wird mit dem ersten Gaskanal 14 verbunden. Ein anderer Teil der Öffnungen 26, 27 wird mit dem zweiten Gaskanal 15 verbunden. Hierüber wird das Gas bzw. Gasgemisch homogen in den Reaktionsbereich 16 geführt.

Der Querschnitt bzw. der Durchmesser der Gaskanäle 14, 15 kann unterschiedlich zueinander ausgebildet sein. Im vorliegenden Ausführungsbeispiel ist der Querschnitt des darunterliegenden zweiten Gaskanals 15 geringer ausgelegt als der Querschnitt des ersten Gaskanals 14. Hierdurch lassen sich unterschiedliche Strömungsgeschwindigkeiten in den einzelnen Gaskanälen 14, 15 erzielen. Dies kann einstellbar ausgestaltet sein, indem beispielsweise der Querschnitt durch einen sich ausdehnenden Körper in einem der Gaskanäle 14, 15, wie einem Piezokristall, verjüngt bzw. erweitert wird. Durch Anlegen verschiedener Spannungen lässt sich nämlich das Volumen eines Piezokristalls variieren. Damit lässt sich dann der Durchmesser bzw. der Querschnitt der Gaskanäle 14, 15, durch den das Gas bzw. Gasgemisch strömt, verändern.

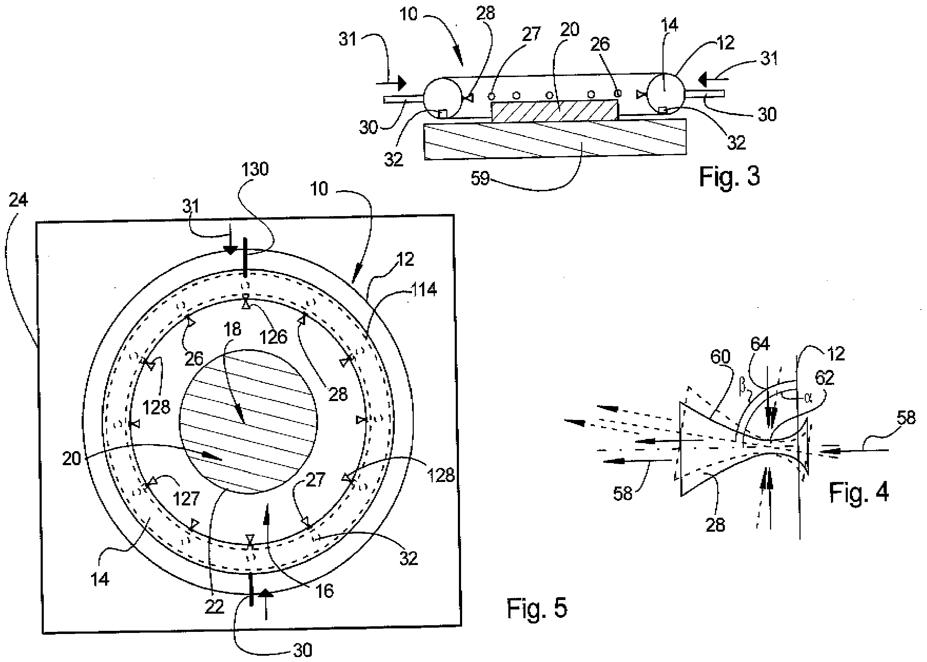

Die Öffnungen 26, 27 sind im vorliegenden Ausführungsbeispiel als Lavaldüsen 28 ausgebildet. Die Lavaldüsen 28 begünstigen ein optimales Einströmen eines Reaktionsgases von dem Gaskanal 14 in den Reaktionsbereich 16. Der vertikale und horizontale Austrittswinkel a, β der Lavaldüsen 28 ist variabel einstellbar ausgebildet, wie auch in Fig. 4 zu sehen ist. Ferner lässt sich der Querschnitt der Lavaldüsen 28 zur Optimierung des einströmenden Gases in den Reaktionsbereich 16 variieren.

An dem Grundkörper 12 sind Gaszuführungen 30 für die ringförmigen Gaskanäle 14, 15 angeordnet. Um eine möglichst gleichmäßige und homogene Gasverteilung an den Öffnungen 26, 27 vorzufinden, Ist im Bereich jeder Öffnung 26, 27 eine separate Gaszuführung 30 zugeordnet. Hierdurch wird vermieden bzw. erheblich reduziert, dass es zu lokalen Druckschwankungen in den Gaskanälen 14, 15 kommt. Die Pfeile 31 zeigen die Richtung des in den Gaskanal 14 einströmenden Reaktionsgases an.

Der Reaktionsraum 24 ist üblicherweise von sämtlichen Gasen leer gepumpt. Es gelangt nur noch das Gas, welches von einer nicht dargestellten Gasressource über die Gaszuführungen 30, über den Gaskanal 14 und durch die Öffnungen 26, 27 in den Reaktionsbereich 16 zur Reaktion mit dem Substrat 20 geführt wird. Jede der Gaszuführungen 30 ist mit einer solchen Gasressource verbunden.

In dem Gaskanal 14 sind Heizungen 32 zur lokalen Erwärmung des Reaktionsgases vorgesehen. Jede der Heizungen 32 kann individuell zur lokalen Erwärmung des Reaktionsgases angesteuert werden. Über die Erwärmung des Reaktionsgases lässt sich auch der lokale Druck im Gaskanal 14 für einen gleichmäßigen Austritt durch die Öffnungen 26, 27 optimieren.

Drucksensoren 34 und Temperatursensoren 36 überwachen den Druck bzw. die Temperatur im Gaskanal 14. Die mit den Drucksensoren 34 und Temperatursensoren 36 ermittelten Messwerte werden insbesondere auch dazu benutzt, um die Heizungen 32 und die Lavaldüsen 28 zur Optimierung anzusteuern. Durch die Strömungssensoren 38 lassen sich die Strömungsverhältnisse in dem Gaskanal 14 feststellen.

In Fig. 2 wird ein weiteres Ausführungsbeispiel für den erfindungsgemäßen Gasinjektor 10 gezeigt. Während bei dem Ausführungsbeispiel von Fig. 1 jeder Öffnung 26, 27 eine einzelne Gaszuführung 30 zugeordnet wurde, reicht im vorliegenden Ausführungsbeispiel gemäß Fig. 2 eine einzige Gaszuführung 40. Statt der einzelnen Gaszuführungen 30 ist hier parallel zum Gaskanal 14 ein Bypass 42 vorgesehen. Soweit Fig. 2 der Fig. 1 aber entspricht, werden auch dieselben Bezugszeichen gewählt. Der Gasinjektor 10 befindet sich in dem Reaktionsraum 24. In dem Reaktionsbereich 16 des Reaktionsraums 24 befindet sich das Substrat 20.

Gaszuführung 40 wird an den Grundkörper 12 angeschlossen und mit dem Gaskanal 14 mit einem ersten Verbindungsteil 44 an der Verbindungsstelle 46 verbunden. An dem ersten Verbindungsteil 44, ist ein Abzweig 48 vorgesehen, welcher in den Bypass 42 mündet. Der Bypass 42 führt im vorliegenden Ausführungsbeispiel zu einem der Verbindungsstelle 46 gegenüberliegenden zweiten Verbindungsteil 50 an einer weiteren Verbindungsstelle 52 zum Gaskanal 14. Das Verbindungsteil 50 ist ebenfalls mit dem Gaskanal 14 des Grundkörpers 12 und dem Bypass 42 verbunden. Die Strömungsrichtung durch den Bypass 42 wird hier mit Pfeil 53 angedeutet.

Das Reaktionsgas strömt nun über die zwei Verbindungsstellen 46, 52 in den Gaskanal 14 des Grundkörpers 12. Das Gas wird anschließend durch die Lavaldüsen 28 der Öffnungen 26, 27 in den Reaktionsbereich 16 geleitet. Der Gasinjektor 10 hat in dieser Anordnung konstruktionsbedingt nur eine Gaszuführung 40, welche über den Bypass 42 auf die Verbindungsstellen 46, 52 verteilt wird. Die Öffnungen 26, 27 bilden hier daher zwei Gruppenverbünde 54, 56, welche durch gestrichelte Linien angedeutet werden. Dabei wird die eine Hälfte der Öffnungen 26, 27 des Gruppenverbunds 54 eher über die Verbindungsstelle 46 und die andere Hälfte der Öffnungen 27 des Gruppenverbunds 56 eher mit Reaktionsgas über die Verbindungsstelle 52 versorgt. Hierdurch wird strömungstechnisch eine bessere Verteilung des Reaktionsgases in dem Gaskanal 14 bewirkt. Die Heizungen 32 im Gaskanal 14 des Grundkörpers 12 sind in diesem Ausführungsbeispiel in geringerer Anzahl gegenüber dem Ausführungsbeispiel von Fig. 1 vorgesehen. Die Funktionsweise der Heizungen 32 ist aber Identisch zum vorherigen Ausführungsbeispiel von Fig. 1

Fig. 3 zeigt in einer schematischen Prinzipskizze den Schnitt des Gasinjektors 10 mit den Lavaldüsen 28 gemäß Fig. 1. Aus den nicht dargestellten Gasressourcen wird Gas über die Gaszuführungen 30 in den Gaskanal 14 des Grundkörpers 12 geliefert. Der ringförmige Grundkörper 12 des Gasinjektors 10 umschließt das Substrat 20 in dem Reaktionsbereich 16. Das Substrat 20 befindet sich dabei auf einem Substrathalter 59. Über die Öffnungen 26, 27 gelangt das Gas zum Substrat 20. Dabei helfen die radialsymmetrisch angeordneten Lavaldüsen 28 für eine gleichmäßige Strömungsverteilung des Gases in dem Reaktionsbereich 16. In dem Gaskanal 14 sind ferner die Heizungen 32 schematisch dargestellt, Die Heizungen 32 können durch Erhitzen des Gases den Gasdruck verändern. Hierdurch lässt sich der Druck im Gaskanal 14 mit einer geeigneten Steuerung, die dem Fachmann bekannt ist, möglichst optimiert regeln bzw. einstellen.

In Fig. 4 wird in einer schematischen Prinzipskizze der Schnitt der variablen Lavaldüse 28, wie sie bei dem Gasinjektor 10 verwendet wird, gezeigt. Das Gas strömt durch die Lavaldüse 28. Dabei strömt es jeweils in einem bestimmten vertikalen Austrittswinkel α und einem horizontalen Austrittswinkel β gegenüber einer tangentialen Fläche des Grundkörpers 12 - im Bereich der Öffnung 26, 27 - aus. Dort benetzt das Reaktionsgas das Substrat 20. Mit der Darstellung von Fig. 4 soll die Einstellbarkeit der Austrittsrichtung 58 des ausströmenden Gases aus der Lavaldüse 28 angedeutet werden. Der Einfachheit halber wird hier nur der vertikale Austrittswinkel α dargestellt. Die gestrichelte Linie deutet beispielhaft einen geänderten Austrittswinkel α' an. Die Lavaldüse 28 gleicht vereinfacht einem Rohr 60, welches an einer Stelle 62 im Querschnitt verjüngt ist. Mit Pfeilen 64 wird angedeutet, dass die Verjüngung 62 im Querschnitt variabel und einstellbar ausgestaltet ist. Pfeile 64 sollen die die Variabilität bei der Verjüngung 62 andeuten. Hierdurch lässt sich die Strömungsgeschwindigkeit durch die Lavaldüsen 28 bei Bedarf einstellen.

In Fig. 5 wird ein weiteres Ausführungsbeispiel für den erfindungsgemäßen Gasinjektor 10 beschrieben. Soweit die Abbildung mit den vorherigen Figuren übereinstimmt, werden auch die gleichen Bezugszeichen verwendet. Im Gegensatz zu den vorherigen Figuren 1 und 2 sind wenigstens zwei unabhängige Gaskanäle 14, 114 in dem Grundkörper 12 vorgesehen. Dies unabhängigen Gaskanäle 14, 114 werden dabei auch von unabhängigen Gaszuführungen 30, 130 jeweils mit einem Gas gespeist. Die Art des Gases oder auch Gasgemisches kann hierbei jeweils bei den Gaszuführungen 30, 130 unterschiedlich sein und variieren. Öffnungen 26, 27 des ersten Gaskanals 14 wechseln sich mit Öffnungen 126, 127 des zweiten Gaskanals 130 in vorliegendem Ausführungsbeispiel ab und sind jeweils als Lavaldüsen 28, 128 ausgebildet. Die Anordnungen der Öffnungen 26, 27, 126, 127 können jeweils aber auch variieren.

Die Lavaldüsen 28, 128 begünstigen wiederum ein optimales Einströmen der Reaktionsgase von den Gaskanälen 14, 114 in den Reaktionsbereich 16. Der vertikale und horizontale Austrittswinkel α, β der Lavaldüsen 28 ist variabel einstellbar ausgebildet, wie auch in Fig. 4 zu sehen ist. Ferner lässt sich der Querschnitt der Lavaldüsen 28, 128 zur Optimierung des einströmenden Gases in den Reaktionsbereich 16 variieren.

Bei Bedarf können die unabhängigen Gaskanäle 14, 114 auch mit unterschiedlichen Gasdrücken beaufschlagt werden, um schließlich eine geeignete Reaktion im Reaktionsbereich 16 des Reaktionsraum 24 mit dem Substrat 20 herbeizuführen.

| | | | |
|---|---|---|---|
| | | 59 | Substrathalter |
| **Bezugszeichenliste** | | 60 | Rohr |
| | | 62 | Verjüngung im Querschnitt |
| 10 | Gasinjektor | 64 | Pfeile |
| 12 | Ringförmiger Grundkörper | 114 | Zweiter unabhängiger Gaskanal |
| 14 | Erster Gaskanal | 126 | Öffnungen |
| 15 | Zweiter Gaskanal | 127 | Öffnungen |
| 16 | Reaktionsbereich | 128 | Lavaldüsen |
| 18 | Zentrum des Reaktionsbereichs | 130 | Gaszuführungen |
| 20 | Substrat | | |
| 22 | Wafer | | |
| 24 | Reaktionsraum | | |
| 26, 27 | Öffnungen | | |
| 28 | Lavaldüsen | | |
| 30 | Gaszuführungen | | |
| 31 | Pfeile für Strömungsrichtung | | |
| 32 | Heizungen | | |
| 34 | Drucksensoren | | |
| 36 | Temperatursensoren | | |
| 38 | Strömungssensoren | | |
| 40 | Gaszuführung | | |
| 42 | Bypass | | |
| 44 | erstes Verbindungsteil | | |
| 46 | Verbindungsstelle | | |
| 48 | Abzweig | | |
| 50 | Zweites Verbindungsteil | | |
| 52 | Verbindungsstelle | | |
| 53 | Pfeil für Strömungsrichtung im Bypass | | |
| 54, 56 | Gruppenverbund | | |
| 58 | Austrittsrichtung | | |

## Patentansprüche

1. Gasinjektor (10) zum Zuführen von Gas oder eines Gasgemisches in einen Reaktionsbereich (16), umfassend
a) einen Grundkörper (12) mit einem Gaskanal (14),
b) eine erste Öffnung (26) oder einen ersten Gruppenverbund (54) von Öffnungen (26) in dem Grundkörper (12), über welche das Gas oder Gasgemisch aus dem ersten Gaskanal (14) in den Reaktionsbereich (16) gelangt,
c) eine zweite Öffnung (27) oder ein zweiter Gruppenverbund (56) von Öffnungen (27) im Grundkörper (12) vorgesehen ist, über welche das Gas oder Gasgemisch ebenfalls aus dem Gaskanal (14) in den Reaktionsbereich (16) gelangt, wobei
d) den Öffnungen (26, 27) oder den Gruppenverbünden (54, 56) von Öffnungen (26, 27) eine Gaszuführung (40) im Grundkörper (12) am Gaskanal (14) zugeordnet ist,
**dadurch gekennzeichnet, dass**
e) die Gaszuführung (40) mit dem Gaskanal (14) mit einem ersten Verbindungsteil (44) an einer Verbindungsstelle (46) verbunden ist, wobei an dem ersten Verbindungsteil (44) ein Abzweig (48) vorgesehen ist, welcher in einen Bypass (42) mündet und der Bypass (42) zu einem zweiten gegenüberliegenden Verbindungsteil (50) an einer weiteren Verbindungsstelle (52) führt, welches ebenfalls mit dem Gaskanal (14) des Grundkörpers (12) verbunden ist, wobei das Gas oder Gasgemisch über die zwei Verbindungsstellen (46, 52) in den Gaskanal (14) des Grundkörpers (12) strömt.

2. Gasinjektor (10) zum Zuführen von Gas oder eines Gasgemisches in einen Reaktionsbereich (16) nach Anspruch 1, **dadurch gekennzeichnet, dass** die als Bypass (42) ausgebildete Gaszuführung (40) einen unterschiedlichen Durchmesser und/oder Länge zum Gaskanal (14) aufweist.

3. Gasinjektor (10) zum Zuführen von Gas oder eines Gasgemisches in einen Reaktionsbereich (16) nach Anspruch 2, **dadurch gekennzeichnet, dass** der Durchmesser und/oder die Länge der Gaszuführung (40) einstellbar und/oder veränderbar ausgebildet ist.

4. Gasinjektor (10) zum Zuführen von Gas oder eines Gasgemisches in einen Reaktionsbereich (16) nach einem der Ansprüche 1 oder 2, **dadurch gekennzeichnet, dass** der Reaktionsbereich (16) in einem geschlossenen Reaktionsraum (24) vorgesehen ist.

5. Gasinjektor (10) zum Zuführen von Gas oder eines Gasgemisches in einen Reaktionsbereich (16) nach einem der Ansprüche 1 bis 3, **dadurch gekennzeichnet, dass** die Öffnung (26) bzw. die Öffnungen (26, 27) jeweils als eine Lavaldüse (28) ausgebildet ist.

6. Gasinjektor (10) zum Zuführen von Gas oder eines Gasgemisches in einen Reaktionsbereich (16) nach einem der Ansprüche 1 bis 4, **dadurch gekennzeichnet, dass** der Austrittswinkel (α, β) der Öffnung (26) bzw. der Öffnungen (26, 27) in eine horizontale und/oder eine vertikale Richtung verstellbar ausgestaltet ist.

7. Gasinjektor (10) zum Zuführen von Gas oder eines Gasgemisches in einen Reaktionsbereich (16) nach einem der Ansprüche 1 bis 5, **dadurch gekennzeichnet, dass** der Öffnungswinkel und/oder der Öffnungsdurchmesser der Öffnung (26) bzw. der Öffnungen (26, 27) variabel ausgestaltet Ist.

8. Gasinjektor (10) zum Zuführen von Gas oder eines Gasgemisches In einen Reaktionsbereich (16) nach einem der Ansprüche 1 bis 6, **dadurch gekennzeichnet, dass** eine Heizung (32) zur Erwärmung des Gases vorgesehen ist.

9. Gasinjektor (10) zum Zuführen von Gas oder eines Gasgemisches in einen Reaktionsbereich (16) nach Anspruch 7, **dadurch gekennzeichnet, dass** eine Heizung (32) zur Erwärmung des Gases an jeder Öffnung (26, 27) vorgesehen ist, wobei jede Heizung (32) individuell ansteuerbar und beheizbar ausgestaltet ist.

10. Gasinjektor (10) zum Zuführen von Gas oder eines Gasgemisches in einen Reaktionsbereich (16) nach einem der Ansprüche 7 oder 8, **dadurch gekennzeichnet, dass** ein Temperaturmesssensor (36) vorgesehen ist, welcher die Temperatur des Gasinjektors (10) zur Steuerung der Heizung (32) überwacht.

11. Gasinjektor (10) zum Zuführen von Gas oder eines Gasgemisches in einen Reaktionsbereich (16) nach einem der Ansprüche 1 bis 9, **dadurch gekennzeichnet, dass** ein Druckmesssensor (34) vorgesehen ist, welcher den Gasdruck des Gasinjektors (10) zur Steuerung des Gasdrucks überwacht.

12. Gasinjektor (10) zum Zuführen von Gas oder eines Gasgemisches in einen Reaktionsbereich (16) nach einem der Ansprüche 1 bis 10, **dadurch gekennzeichnet, dass** der Gasinjektor (10) eine ring- oder polygonartige Struktur aufweist, wobei der Austrittswinkel (α, β) der Öffnung (26) bzw. Öffnungen (26, 27) jeweils zentral ausgerichtet ist.

13. Gasinjektor (10) zum Zuführen von Gas oder eines Gasgemisches in einen Reaktionsbereich (16) nach einem der Ansprüche 1 bis 11, **dadurch gekennzeichnet, dass** der Gasinjektor (10) einen keramischen Grundkörper (12) enthält.

14. Gasinjektor (10) zum Zuführen von Gas oder eines Gasgemisches in einen Reaktionsbereich (16) nach einem der Ansprüche 1 bis 12, **dadurch gekennzeichnet, dass** die Öffnungen oder Gruppenverbände (54, 56) von Öffnungen (26, 27) symmetrisch am Grundkörper (12) angeordnet sind.

15. Gasinjektor (10) zum Zuführen von Gas oder eines Gasgemisches in einen Reaktionsbereich (16) nach einem der Ansprüche 1 bis 14, **gekennzeichnet durch** einen zum Gaskanal (14) weiteren parallelen Gaskanal (114), welcher in dem Grundkörper (12) angeordnet ist, wobei für den weiteren Gaskanal (114) Öffnungen oder ein Gruppenverbund von Öffnungen (126) vorgesehen sind, über welche ein weiteres Gas oder Gasgemisch aus dem weiteres Gaskanal (114) unabhängig von dem ersten Gaskanal (14) in den Reaktionsbereich (16) gelangt.

## Claims

1. A gas injector (10) for supplying a gas or a gas mixture to a reaction region (16), comprising
a) a base body (12) with a gas channel (14);
b) a first opening (26) or a first group (54) of openings (26) in the base body (12), via which the gas or gas mixture passes from the first gas channel (14) into the reaction region (16);
c) a second opening (27) or a second group (56) of openings (27) is provided in the base body (12), via which the gas or gas mixture likewise passes from the gas channel (14) into the reaction region (16), wherein
d) the openings (26, 27) or the group (54, 56) of openings (26, 27) are provided with a gas supply (40) in the base body (12) on the gas channel (14);
**characterized in that**
e) the gas supply (40) is connected to the gas channel (14) by a first connection part (44) at a junction (46), wherein the first connection part (44) is provided with a branch (48) that leads to a bypass (42), and the bypass (42) leads to a second opposing connection part (50) on another junction (52), which is also connected to the gas channel (14) of the base body (12), wherein the gas or gas mixture flows into the gas channel (14) of the base body (12) via the two junctions (46, 52).

2. A gas injector (10) for supplying gas or a gas mixture to a reaction region (16) according to claim 1, **characterized in that** the gas supply (40), which is designed as a bypass (42), has a different diameter and/or a different length to the gas channel (14).

3. A gas injector (10) for supplying gas or a gas mixture to a reaction region (16) according to claim 2, **characterized in that** the diameter and/or length of the gas supply (40) can be adjusted or changed.

4. A gas injector (10) for supplying gas or a gas mixture to a reaction region (16) according to claim 1 or 2, **characterized in that** the reaction region (16) is provided in a closed reaction chamber (24).

5. A gas injector (10) for supplying gas or a gas mixture to a reaction region (16) according to one of claims 1 to 3, **characterized in that** the opening (26) or the openings (26, 27) are each formed as a de Laval nozzle (28).

6. A gas injector (10) for supplying gas or a gas mixture to a reaction region (16) according to one of claims 1 to 4, **characterized in that** the exit angles (α, β) of the opening (26) or the openings (26, 27) can be adjusted in a horizontal and/or vertical direction.

7. A gas injector (10) for supplying gas or a gas mixture to a reaction region (16) according to one of claims 1 to 5, **characterized In that** the opening angle and/or the diameter of the opening (26) or of the openings (26, 27) are designed to be variable.

8. A gas injector (10) for supplying gas or a gas mixture to a reaction region (16) according to one of claims 1 to 6, **characterized in that** a heater (32) is provided for heating the gas.

9. A gas injector (10) for supplying gas or a gas mixture to a reaction region (16) according to claim 7, **characterized in that** a heater (32) is provided on each opening (26, 27) for heating the gas, wherein each heater (32) is designed to be individually controllable and heatable.

10. A gas injector (10) for supplying gas or a gas mixture to a reaction region (16) according to one of claims 7 or 8, **characterized in that** a temperature measurement sensor (36) is provided, which monitors the temperature of the gas injector (10) in order to control the heater (32).

11. A gas injector (10) for supplying gas or a gas mixture to a reaction region (16) according to one of claims 1 to 9, **characterized In that** a pressure measurement sensor (34) is provided, which monitors the gas pressure of the gas injector (10) in order to control the gas pressure.

12. A gas injector (10) for supplying gas or a gas mixture to a reaction region (16) according to one of claims 1 to 10, **characterized in that** the gas injector (10) has an annular or polygonal structure, wherein the exit angle (α, β) of the opening (26) or openings (26, 27) are each centrally aligned.

13. A gas injector (10) for supplying gas or a gas mixture to a reaction region (16) according to one of claims 1 to 11, **characterized in that** the gas injector (10) comprises a ceramic base body (12).

14. A gas injector (10) for supplying gas or a gas mixture to a reaction region (16) according to one of claims 1 to 12, **characterized in that** the openings or groups (54, 56) of openings (26, 27) are arranged symmetrically on the base body (12).

15. A gas injector (10) for supplying gas or a gas mixture to a reaction region (16) according to one of claims 1 to 14, **characterized In that** a second gas channel (114) is arranged parallel to the gas channel (14) in the base body (12), wherein openings or a group of openings (126) are provided for the second gas channel (114), through which an additional gas or gas mixture passes from the second gas channel (114) into the reaction region (16) independently of the first gas channel (14).

## Revendications

1. Injecteur de gaz (10) destiné à amener du gaz ou un mélange de gaz dans une zone de réaction (16), comprenant :
(a) un corps de base (12) muni d'un canal pour le gaz (14), (
(b) un premier orifice (26) ou un premier regroupement (54) d'orifices (26) situé dans le corps de base (12), par l'intermédiaire duquel le gaz ou le mélange de gaz passe du premier canal pour le gaz (14) à la zone de réaction (16),
(c) un second orifice (27) ou un second regroupement (56) d'orifices (27) situé dans le corps de base (12) par l'intermédiaire duquel le gaz ou le mélange de gaz passe également du canal pour le gaz (14) à la zone de réaction (16),
(d) une amenée de gaz (40) située dans le corps de base (12) sur le canal pour le gaz (14) étant affectée aux orifices (26, 27) ou au regroupement (54, 56) d'orifices (26, 27), **caractérisé en ce**
(e) l'amenée de gaz (40) est connectée au canal pour le gaz (14) au moyen d'un premier élément de connexion (44) à un point de connexion (46), un embranchement (48) étant prévu sur le premier élément de connexion (44), embranchement débouchant dans une dérivation (42) et la dérivation (42) guidant à un autre point de connexion (52) vers un second élément de connexion opposé (50) qui est également connecté au canal pour le gaz (14) du corps de base (12), le gaz ou le mélange de gaz traversant les deux points de connexion (46, 52) pour s'écouler dans le canal pour le gaz (14) du corps de base (12) .

2. Injecteur de gaz (10) destiné à amener du gaz ou un mélange de gaz dans une zone de réaction (16), selon la revendication 1, **caractérisé en ce que** l'amenée de gaz (40) configurée sous forme de dérivation (42) présente un diamètre différent et/ou une longueur différente par rapport au canal pour le gaz (14).

3. Injecteur de gaz (10) destiné à amener du gaz ou un mélange de gaz dans une zone de réaction (16), selon la revendication 2, **caractérisé en ce que** le diamètre et/ou la longueur de l'amenée de gaz (40) est configurée de sorte à pouvoir être réglée et/ou modifiée.

4. Injecteur de gaz (10) destiné à amener du gaz ou un mélange de gaz dans une zone de réaction (16), selon l'une quelconque des revendications 1 ou 2, **caractérisé en ce que** la zone de réaction (16) est prévue dans un espace de réaction clos (24).

5. Injecteur de gaz (10) destiné à amener du gaz ou un mélange de gaz dans une zone de réaction (16), selon l'une quelconque des revendications 1 à 3, **caractérisé en ce que** soit l'orifice (26) soit les orifices (26, 27) sont configurés chacun sous forme de tuyère de Laval (28).

6. Injecteur de gaz (10) destiné à amener du gaz ou un mélange de gaz dans une zone de réaction (16), selon l'une quelconque des revendications 1 à 4, **caractérisé en ce que** l'angle d'émergence (α, β) soit de l'orifice (26) soit des orifices (26, 27) est configuré de sorte à pouvoir être réglé dans un sens horizontal et/ou vertical.

7. Injecteur de gaz (10) destiné à amener du gaz ou un mélange de gaz dans une zone de réaction (16), selon l'une quelconque des revendications 1 à 5, **caractérisé en ce que** l'angle d'ouverture et/ou le diamètre d'ouverture soit de l'orifice (26) soit des orifices (25, 27) est configuré de sorte à pouvoir varier.

8. Injecteur de gaz (10) destiné à amener du gaz ou un mélange de gaz dans une zone de réaction (16), selon l'une quelconque des revendications 1 à 6, **caractérisé en ce qu'**il est prévu un dispositif de chauffage (32) destiné à chauffer le gaz.

9. Injecteur de gaz (10) destiné à amener du gaz ou un mélange de gaz dans une zone de réaction (16), selon la revendication 7, **caractérisé en ce qu'**il est prévu un dispositif de chauffage (32) destiné à chauffer le gaz à chaque orifice (26, 27), chaque dispositif de chauffage (32) étant configuré de sorte à pouvoir être commandé et chauffé individuellement.

10. Injecteur de gaz (10) destiné à amener du gaz ou un mélange de gaz dans une zone de réaction (16), selon l'une quelconque des revendications 7 ou 8, **caractérisé en ce qu'**il est prévu un capteur de mesure de la température (36) qui surveille la température de l'injecteur de gaz (10) afin de commander le dispositif de chauffage (32).

11. Injecteur de gaz (10) destiné à amener du gaz ou un mélange de gaz dans une zone de réaction (16), selon l'une quelconque des revendications 1 à 9, **caractérisé en ce qu'**il est prévu un capteur de mesure de la pression (34) qui surveille la pression du gaz de l'injecteur de gaz (10) afin de commander la pression du gaz.

12. Injecteur de gaz (10) destiné à amener du gaz ou un mélange de gaz dans une zone de réaction (16), selon l'une quelconque des revendications 1 à 10, **caractérisé en ce que** l'injecteur de gaz (10) présente une structure en forme d'anneau ou de polygone, l'angle d'émergence (α, β) soit de l'orifice (26) soit des orifices (26, 27) étant orienté à chaque fois centralement.

13. Injecteur de gaz (10) destiné à amener du gaz ou un mélange de gaz dans une zone de réaction (16), selon l'une quelconque des revendications 1 à 11, **caractérisé en ce que** l'injecteur de gaz (10) comprend un corps de base (12) en céramique.

14. Injecteur de gaz (10) destiné à amener du gaz ou un mélange de gaz dans une zone de réaction (16), selon l'une quelconque des revendications 1 à 12, **caractérisé en ce que** les orifices ou regroupements (54, 56) d'orifices (26, 27) sont disposés symétriquement sur le corps de base (12).

15. Injecteur de gaz (10) destiné à amener du gaz ou un mélange de gaz dans une zone de réaction (16), selon l'une quelconque des revendications 1 à 14, **caractérisé par** un canal pour le gaz supplémentaire (114) parallèle au canal pour le gaz (14) qui est disposé dans le corps de base (12), des orifices ou un regroupement d'orifices (126) permettant à du gaz ou à un mélange de gaz supplémentaire de passer du canal pour le gaz supplémentaire (114) à la zone de réaction (16) indépendamment du premier canal pour le gaz (14) étant prévu pour le canal pour le gaz supplémentaire (114).
